Europäisches Patentamt

European Patent Office

Office européen des brevets

(11) Publication number: **0 231 090**

**A2**

## (12) EUROPEAN PATENT APPLICATION

(21) Application number: **87300443.6**

(22) Date of filing: **20.01.87**

(51) Int. Cl.⁴: **G 06 K 19/06**

(30) Priority: **20.01.86 JP 8090/86**

(43) Date of publication of application:
**05.08.87 Bulletin 87/32**

(84) Designated Contracting States:
**AT BE CH ES FR GB IT LI LU NL SE**

(71) Applicant: **ITT INDUSTRIES INC.**
**320 Park Avenue**
**New York, NY 10022 (US)**

(72) Inventor: **Ohkubo, Isao**
**5-4-1-2-6 Shibokuhoncho Miyamae-IKU**
**Kawasake-shi Kanagawa-Ken (JP)**

**Aiba, Shintaro**
**C-108, 1460-7 Ichinomiya Samukawa-Cho**
**Koza-gun Kanagawa-Pref. (JP)**

(74) Representative: **Vaufrouard, John Charles**
**ITT Patent Department UK Maidstone Road Foots Cray**
**Sidcup KentDA14 5HT (GB)**

(54) **IC card and mating socket.**

(57) A credit card type small thin rectangular IC card (10) includes a battery (14) and an IC comprising a CPU (15), a ROM (15″) and a RAM (15′) mounted on a flexible printed circuit (11) and bonded within an insulative plastic material (12). The printed circuit of the card includes a plurality of electrode terminals (13) exposed in a parallel array along at least one edge of the card which are adapted to engage electrodes of a mating contact. The printed circuit terminals are manufactured by coating copper, nickel and gold over polyamide resin and squeeze finishing the leading edge. The mating socket comprises a generally U-shaped frame having a U-shaped channel adapted to receive the IC card and having internal recessed contacts adapted to engage the terminals of the IC card. The contacts extend from an exterior surface of the frame for interconnection with the circuits of the mating device. Downwardly projecting portions thereof are bent at least twice in the portion penetrating the bottom of the frame.

Fig.1.

Fig.2.

**Description**

## IC CARD AND MATING SOCKET

This invention relates to IC cards and mating sockets of free insertion and withdrawal capability. In the prior art is is commonly known that information memory cards magnetically store information and are being used between banking and other facilities and their customers. The card of this type, the so called magnetic card, is convenient in its own use and is considered to be the only kind of memory card for this application. However the greatest weak point of this type of card it that the amount of information that can be stored thereon is very limited. Also it can furnish information only in response to requirements from outside equipment and does not have logical and calculating functions of its own. In order to eliminate these problems the IC card of the present invention was devised. The present invention also solves interfacing problems by providing an interconnection structure which is inexpensive and can be manufactured in small sizes on thin type cards which contain units such as a battery, a memory, a central processing unit, swiches, etc., both active and passive elements. The invention is to furnish an IC card and also a mating socket which is small and thin sized and free from the various weaknesses described above and to facilitate interconnection between the IC card and mating socket.

According to one aspect of the invention there is provided a flexible IC card of the kind provided with plural electrode terminals in parallel and separate array on at least part of its perimeter which card is coated and bonded with insulating material, characterised in that the card has at least one circuit part including active devices and a battery connected by printed circuit on the card.

Since the card of this invention is capable of manufacture simply by moulding those active/passing elements and other necessary parts on a flexible printed board it is easy to produce and suitable for mass production at low cost. Further because of solid moulding the card can be thinned down to a thickness of less than one millimeter. The connection to outer devices through the socket insures proper mating.

In order that the invention and its various other preferred features may be understood more easily, some embodiments thereof will now be described, by way of example only, with reference to the drawings, in which:-

Figure 1 is an elevation view of an IC card constructed in accordance with the invention.

Figure 2 is a side view of the IC card of Figure 1,

Figure 3 is an enlarged view of the encircled part III of Figure 2,

Figure 4 is a cross-sectional view along the line IV-IV' of Figure 3,

Figure 5A is an enlarged view of an electrode of the IC card,

Figure 5B is a view of the electrode in the width of one millimeter,

Figures 6A and 6B are sectional drawings of a flexible circuit electrode,

Figures 7A and 7B and 8A and 8B are top views of four versions of IC card with edges or projections for polarising the card,

Figure 9 is a partial schematic view of a socket constructed in accordance with a second aspect of the invention,

Figure 10 is an enlarged partial view of the socket of Figure 9,

Figure 11 is a sectional drawing along the lines IX-IX' of Figure 10, and

Figure 12 is an enlarged view of the terminal of the socket of Figures 9 to 11.

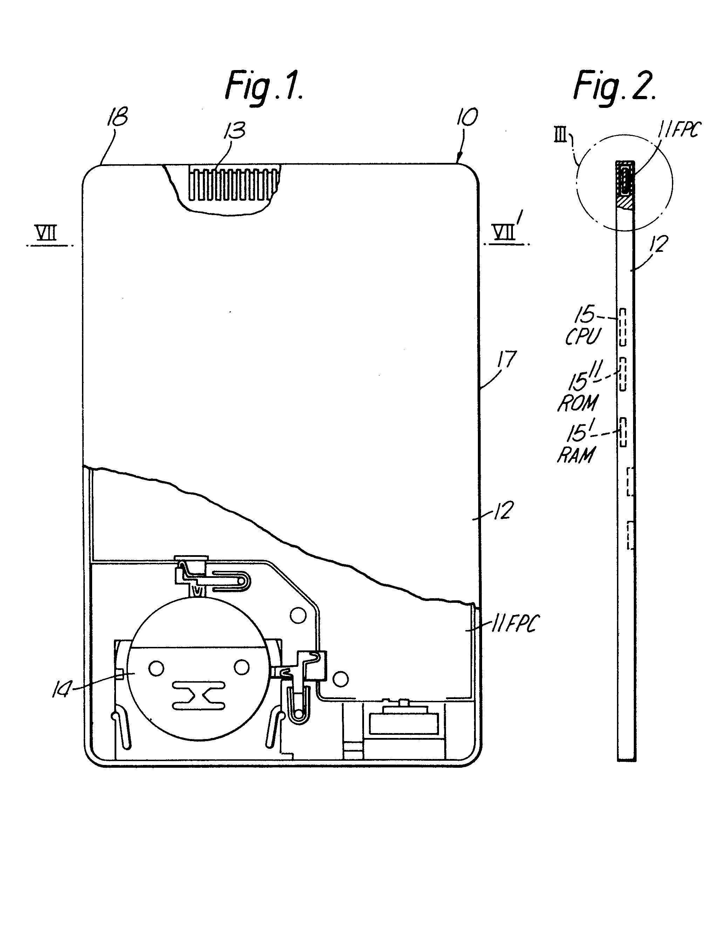

Referring to Figure 1, an IC card 10 has a flexible printed circuit board 11 on both sides of which are installed a CPU 15 a RAM 15' and a ROM 15" with a battery 14 connected by a suitable method. On one side at least of the flexible printed circuit board 11 of Figure 2 there is a connecting conductor coating which connects individual circuit parts, a battery and terminals 13 as mentioned later. These connections are not shown in detail in the drawing.

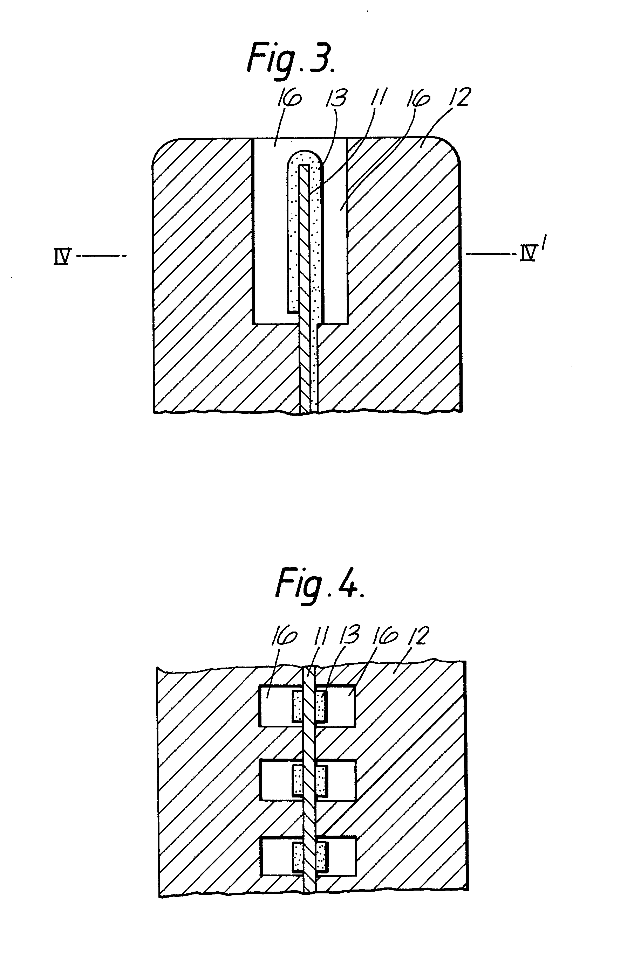

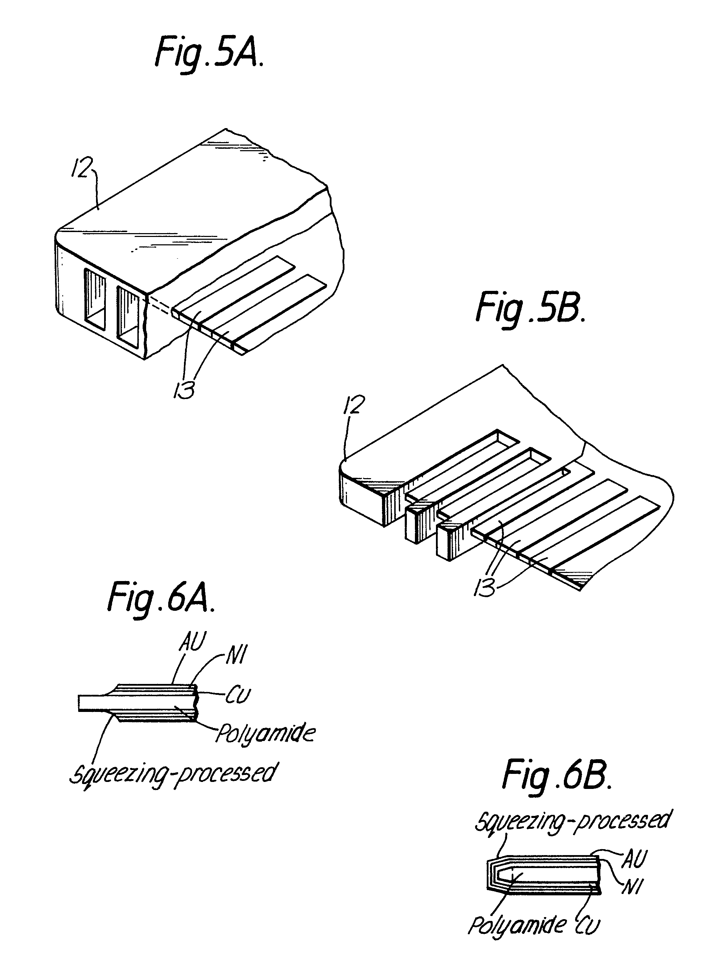

The bulk of both surfaces and sides of the circuit board unit thus assembled is covered and coated by an insulating material 12. Figure 2 is a longitudinal cross-sectional view of the card. The encircled portion III in Figure 2, a part of the IC card, is enlarged in Figure 3. On both sides of the board 11 terminals 13 are provided. The terminals 13 form a mutually parallel array and are spaced from each other by insulating material 12 as shown in Figure 4 which is a cross section cut along the lines IV to IV' of Figure 3. Each terminal is surrounded by a void 16 in the insulating material 12. This structure is used to decrease the force on the terminals and to prevent deformation of the card terminals and the flexible printed circuit card when the IC card has been inserted into a socket as described later. The terminals 13 may be installed on only one side of the flexible printed circuit card but it is more desirable to install them on both sides by folding over the upper end of the card 11 as shown in Figures 3 and 4. Thus contacts on both sides of the terminals insure highly reliable mating and in the case of twenty contacts or less it is possible to have contact at four points and nondirectional insertion of the card. (See Figures 5A and 5B).

The terminal 13 is made of conductive material, desirably from metal, and squeezing finishing is preferable. This contributes to long life and together with the easy zero insertion force method assures mating and unmating of over ten thousand cycles. The flexible printed circuit terminals are manufactured by coating copper, nickel and gold in this order over a polyamide resin, for example, as shown in Figures 6A and 6B. In the example illustrated these terminals are seen only along a shorter side of a rectangular IC card. However they are not to be limited to such a side but can be installed along any one or more of the sides, for example on two shorter sides or on suitable positions in plural groups along four sides.

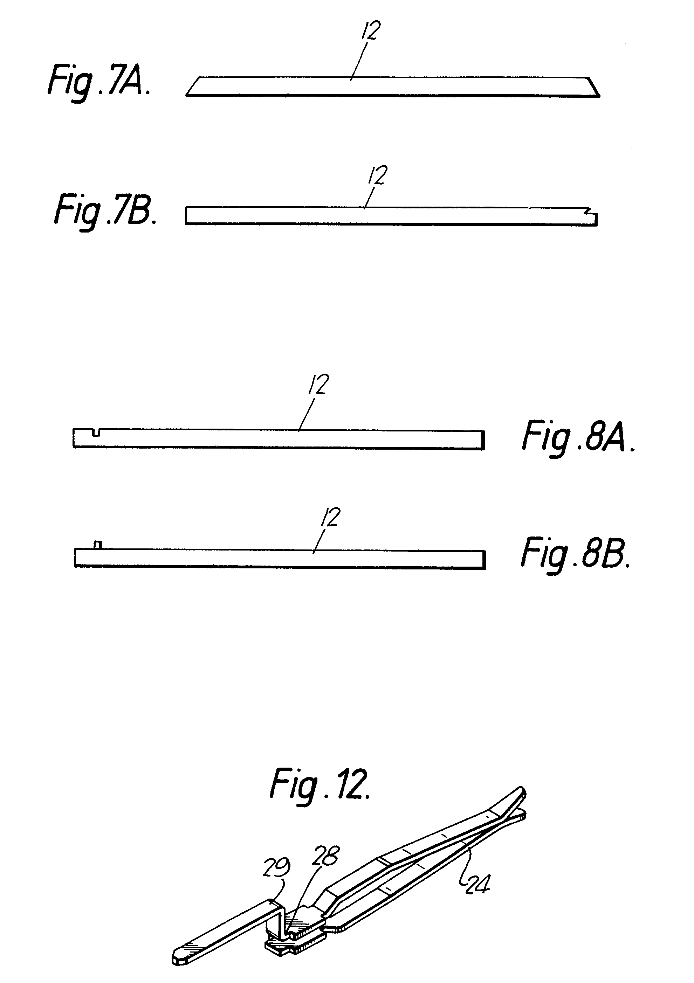

Although in the previous example, the IC cards shown are rectangular any other configuration may be used as required. In the case of the previous example of IC card the two sides 17 and 18 perpendicular to the side containing terminals 13 are desirable to be non revolvable when viewed from the side on extending lines of those two sides. For example, when Figure 1 is cut along the line VII-VII' the configurations of cross-sections should preferably be like Figures 7A or 7B. The forms of 7A and 7B are very effective for preventing wrong insertion of the socket by polarising the card. Instead of the above mentioned asymmetry formed by the two sides a river channel may be made along a line somewhat inside of one side of the card as shown in Figure 8A while making a mating rib on the socket or vice versa with a rib along the card as in 8B and a mating channel in the socket.

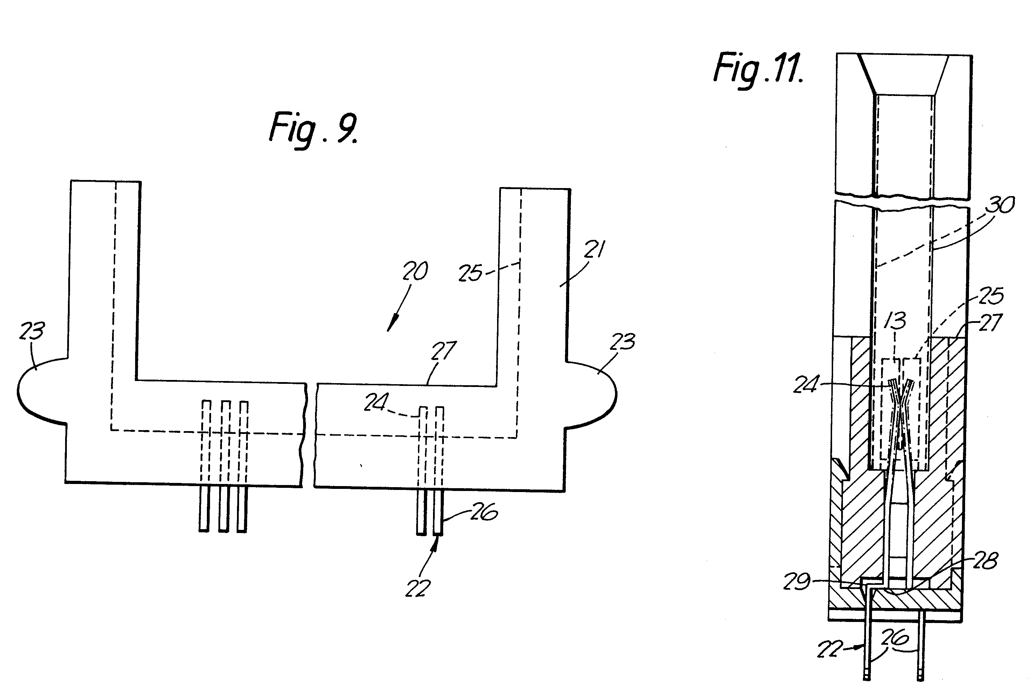

A card of this type can be connected to outside devices through the terminals 13. It may however have so many terminals, for example some 20 pieces, that the pitch or space between adjacent terminals is limited, for example to 1.27 millimeters. It is rather difficult for various reasons to install corresponding contacts on the outside device. Therefore it is desirable to provide a socket through which the IC card can be connected to an outside device. Turning to Figure 9, this Figure shows socket 20 which consists of an outer frame 21 of U shape made from insulating material, preferably plastics and pins 22 which extend through the bottom part of the body perpendicularly. The body may be provided with two lugs 23, one on each side. Inside of the outer frame 21 are provided a channel 25 of U shape for receiving the IC card and containing inner terminals whose upper ends 24 connect with terminals on the card. The position of the channel 25 is in the middle of the U-shaped frame in the direction of thickness as shown in Figure 11. The pin 22 consists of a lower terminal 26 which projects out of the bottom of the frame and the interconnecting terminal 24 which extends from the lower terminal 26 upwards and extends through the bottom into the channel 25.

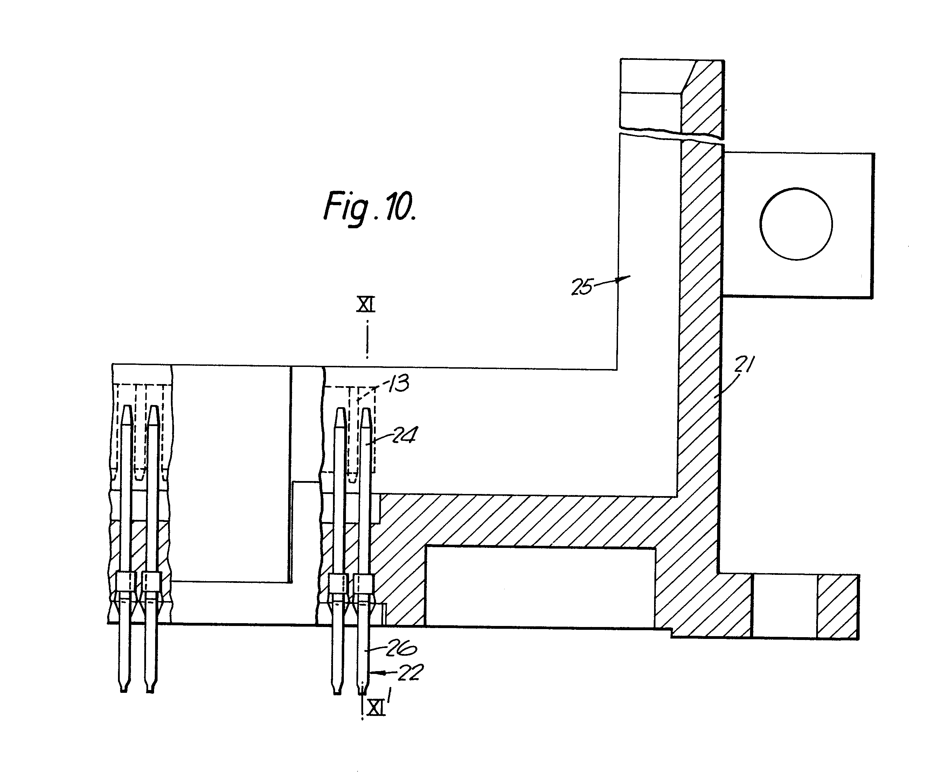

These sockets can be fabricated by first arraying a required number of pins 22 in a mould and then by rejecting plastics, for example, into the mould. The upper end 24 of the pin 22 is desirably flush with or somewhat lower than the upper brim 27 of the U shaped channel 25 on the bottom as shown in Figures 10 and 11. Thus fabricated the IC card may be guided along the channel 25 and its terminals 13 contact the inner face of terminals 24 of the socket 20 completing the required connection.

Further in order to prevent dust from entering into the channel when not in use the inside walls of the channel between 24 and 27 can be filled by some suitable methods or those parts of the channel can be provided with a flexible obstruction which permits insertion of the card and restores its original form after withdrawal of the card. This is not shown in the figures.

The forms of the channel 25 on the right and left sides of the U-shaped frame may be of different mating types for accomodating the sides of the IC card as shown in Figures 7A or 7B or may be provided with a rib or indented groove on one side to mate with the card as shown in Figures 8A or 8B. By means such as this polarisation is provided and wrongful insertion of the card can be avoided.

The interconnecting terminal 24 of the pin when contacted with either side of the terminal 13 on the card makes connection but this tends to load bending strength on the terminals of the IC card and then on the flexible printed circuit card which is undesirable. To avoid this it is desirable to provide two pins 22 into the body of the frame as shown in Figures 11 and 12 so that they can hold the terminal 13 therebetween. Pin 22 is subjected to repetitions of pushing and pulling load at every insertion and withdrawal between the card and the socket. During these repetitions the pin if of straight form is liable to fall off. In order to avoid this it is desirable to bend the pin, preferably right angled at least twice such as at 28 and 29 in the portion which extends through the frame shown in Figures 11 and 12. For practical mating with an outside device it is convenient if every lower end 26 of pins 22 is installed in zig zag array while the inner terminals are arrayed on a single plane. To that end it is desirable to bend twice leftwards, for example, the pins of odd numbers counted from one end and those of even numbers twice rightward as shown in Figure 11.

Based on the structures provided above the IC card can be manufactured in a thickness less than one millemeter or can be freely bent if proper types of reinformcement are provided. In addition to the possible functions mentioned above elimination of wrong card insertions into the socket and provision of rugged sockets can be considered.

## Claims

1. A flexible IC card of the kind provided with plural electrode terminals in parallel and separate array on at least part of its perimeter, which card is coated and bonded with insulating material, characterised in that the card (10) has at least one circuit part including active devices (15, 15' and 15") and a battery (14) connected by printed circuit (11) on the card.

2. A card as claimed in claim 1, characterised in that the electrode terminals (13) are provided and coated on both sides of the card (10) and interconnect the circuit part (11), active devices (15, 15' and 15") and battery (14).

3. A card as claimed in claim 1 or 2, characterised in that the circuit part (11) comprises a CPU (15), a ROM (15') and a RAM (15").

4. A card as claimed in any one of the preceding claims, characterised in that the insulating material (12) has voids (16) of about the width of each electrode terminal with a space between each terminal being covered by the insulating material.

5. A card as claimed in any one of the preceding claims, characterised in that the card (10) is of rectangular shape with the terminals (13) arranged along at least a portion of a side of the rectangle.

6. A card as claimed in claim 5, characterised in that two sides of the rectangle card (10) at right angles to the side having the terminals (13) are of different cross section to polarise the card.

7. A mating socket for a card as claimed in any one of the preceding claims characterised in that it has an outer U-shaped frame (21) made of insulating material and having a U-shaped channel (25) in the wall of the frame in cross direction and a number of metal connecting pins (22) in parallel and separate array mounted in the bottom part of the U-shaped frame (21), the pins having terminals (26) projecting downwardly out of the bottom of the U-shaped frame and extending through the frame upwardly inside the channel but not beyond the brim (27) of the channel.

8. A mating socket as claimed in claims 6 and 7, characterised in that the inside walls of the channel (25) have right and left sides different from each other in configuration of polarisation with the card (10).

9. A mating socket as claimed in claim 7 or 8, characterised in that the upward portions of the terminals comprise two pieces (24) spring biased together to hold a card terminal (13) therebetween.

10. A mating socket as claimed in any one of claims 7 to 9, characterised in that the downwardly projecting portion of the terminals (26) are bent twice (28, 29) at least where they extend through the bottom of the U-shaped frame (21).

## Fig.1.

18  13  10

VII    VII'

17

12

11FPC

14

## Fig.2.

III    11FPC

12

15----
CPU

15''--
ROM

15'--
RAM

0231090

## Fig. 3.

16  13  11  16  12

IV — · —                      · IV′

## Fig. 4.

16  11  13  16  12

## Fig.5A.

12

13

## Fig.5B.

12

13

## Fig.6A.

AU — NI — CU — Polyamide

Squeezing-processed

## Fig.6B.

Squeezing-processed — AU NI

Polyamide CU

0231090

Fig.7A.

*12*

Fig.7B.

*12*

Fig.8A.

*12*

Fig.8B.

*12*

Fig.12.

*29*  *28*

*24*

Fig. 9.

Fig. 11.

# Fig .10.

0231090